(19) Europäisches Patentamt
European Patent Office
Office européen des brevets

(11) **EP 4 261 618 A1**

(12) **EUROPEAN PATENT APPLICATION**

(43) Date of publication:
**18.10.2023 Bulletin 2023/42**

(21) Application number: **22168402.0**

(22) Date of filing: **14.04.2022**

(51) International Patent Classification (IPC):
***G03F 7/20*** (2006.01)

(52) Cooperative Patent Classification (CPC):
**G03F 7/70525; G03F 7/70508; G03F 7/70725; G03F 7/70941**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **BUTLER, Hans**
**5500 AH Veldhoven (NL)**

• **TISSINGH, Luc**
**5500 AH Veldhoven (NL)**
• **EISENBERG, Martin**
**5500 AH Veldhoven (NL)**
• **DE JONGH, Robertus, Johannes, Marinus**
**5500 AH Veldhoven (NL)**

(74) Representative: **ASML Netherlands B.V.**
**Corporate Intellectual Property**
**P.O. Box 324**
**5500 AH Veldhoven (NL)**

(54) **A METHOD OF DETERMINING A CORRECTION FOR CONTROL OF A LITHOGRAPHY AND/OR METROLOGY PROCESS, AND ASSOCIATED DEVICES**

(57) Disclosed is a method of determining a correction for control of at least one first component of a lithographic or metrology apparatus, and associated apparatuses. The method comprises obtaining a trained regression tree model which has been trained to map input data relating to at least one second component of the lithographic or metrology apparatus to a disturbance parameter related to a disturbance of said at least one first component, said disturbance having been caused by said at least one second component; obtaining input data relating to said at least one second component; and determining a compensatory correction for the disturbance parameter from said input data using the trained regression tree model.

FIG. 5

EP 4 261 618 A1

## Description

FIELD

The invention relates to methods of manufacturing devices using lithographic techniques. The invention further relates to computer program products for use in implementing such methods.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

To achieve a required accuracy in positioning of the features, and therefore to minimize parameters such as overlay and edge placement error, accurate and precise control of the stages (e.g., a reticle stage for holding a reticle or mask and at least one wafer stage for holding a wafer or substrate) and/or beam actuators (e.g., beam steering mirrors) is very important. In many cases, such corrections are determined and applied in a feedback loop. However, feedback correction relies on there being an error to correct in the first place; i.e., a correction cannot be determined until an error has occurred.

It is desirable to improve methods for determining a correction for control within a lithography or metrology process, and in particular for providing a feed-forward correction.

SUMMARY

In a first aspect of the invention, there is provided a method of determining a correction for control of at least one first component of a lithographic or metrology apparatus; the method comprising: obtaining a trained regression tree model which has been trained to map input data relating to at least one second component of the lithographic or metrology apparatus to a disturbance parameter related to a disturbance of said at least one first component, said disturbance having been caused by said at least one second component; obtaining input data relating to said at least one second component; and determining a compensatory correction for the disturbance parameter from said input data using the trained regression tree model.

In a second aspect of the invention there is provided a computer program comprising program instructions operable to perform the method of the first aspect, when run on a suitable apparatus, and a non-transient computer program carrier and processing arrangement comprising such a computer program.

In a third aspect of the invention there is provided a lithographic tool for patterning a substrate or measuring a patterned structure on a substrate; the lithographic tool comprising: at least one first component; at least one second component; a processor; and a non-transient computer program carrier comprising a trained regression tree model, having been trained to map input data relating to the at least one second component to a disturbance parameter related to a disturbance of said at least one first component, said disturbance having caused by said at least one second component.

In the context of the third embodiment "a lithographic tool" may comprise any tool used in a lithographic manufacturing process. This may include a lithographic exposure tool or scanner used to perform the exposures in the lithographic manufacturing process, or a metrology tool (such as a scatterometer or scanning electron microscope) used in monitoring and/or control of such a lithographic manufacturing process.

BRIEF DESCRIPTION OF THE DRAWINGS

Embodiments of the invention will now be described, by way of example only, with reference to the accompanying schematic drawings, in which:

- Figure 1 depicts a schematic overview of a first lithographic apparatus;
- Figure 2 depicts a schematic overview of a lithographic cell;
- Figure 3 depicts an EUV lithographic system comprising a lithographic apparatus and a radiation source;
- Figure 4 depicts a schematic illustration of a scatterometry apparatus;
- Figure 5 is an exemplary flow diagram of a method of determining a disturbance parameter using a regression tree model;
- Figure 6 is a flow diagram of a component control loop illustrating how an electromagnetic disturbance force may be obtained for training purposes;
- Figure 7 is an exemplary flow diagram of a method of determining a disturbance parameter using an ensemble of regression tree models; and
- Figure 8 is a flow diagram of a component control loop with a correction or compensatory force applied, as can be determined using a regression tree according to embodiments of the invention.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

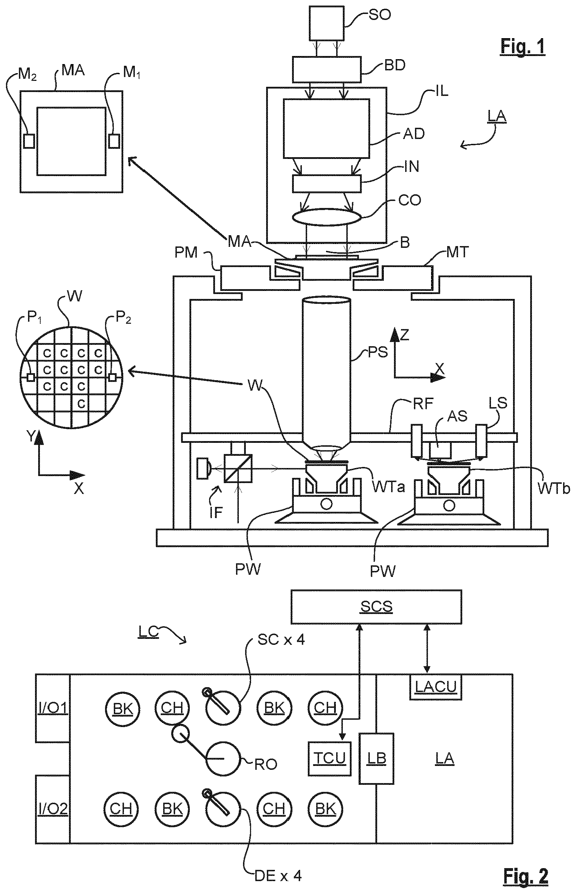

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

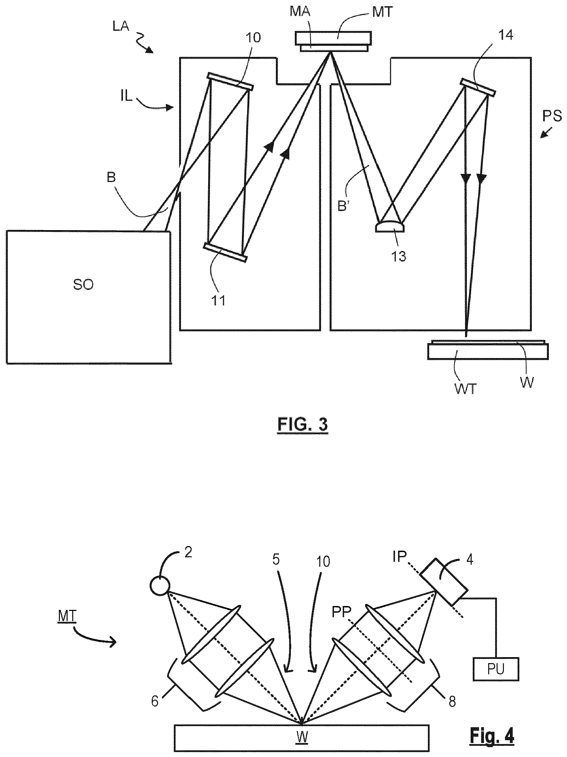

Figure 3 shows an alternative type of lithographic system which uses EUV radiation for exposure. The lithographic system comprises a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

A metrology apparatus, such as a scatterometer MT, is depicted in Figure 4. It comprises a radiation source 2 (e.g., a broadband (white light) radiation source) which projects radiation 5 onto a substrate W via projection optical system 6. The reflected or scattered radiation 8 is collected by an objective lens system 8 and passed to a detector 4. The scattered radiation 8 as detected by detector 4 can then be processed by processing unit PU. Also shown is a pupil plane PP and image plane IP of the objective lens system 8. The terms "pupil plane" and "field plane" within this specification may refer to respectively these planes or any planes conjugate thereto. Such a scatterometer may be configured as a normal-incidence scatterometer or (as shown) an oblique-incidence scatterometer. In some embodiments, the projection optical system 6 and objective lens system 8 are combined; i.e., the same objective lens system is used to both illuminate the substrate and collect the scattered radiation therefrom.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

In lithography machines and metrology machines just described, silicon wafers are moved at extremely high speeds to maximize productivity. In particular, where the machine is an EUV lithography machine such as illustrated in Figure 3, the wafers are exposed to an EUV light pattern (as patterned using a reticle or mask) underneath the Projection Optics Box (POB). Inside the POB, first components such as mirrors (e.g., mirrors 13, 14 in Figure 3) are used to transfer and manipulate/guide the EUV light to create a sharp image on the wafer. These mirrors may be actuated by electromagnetic actuators and may be supported by gravity compensators for stabilization purposes. When a second component such as a wafer stage is close to the POB during exposure, electromagnetic fields create disturbances that act on the components inside the POB. The fast movement and high acceleration of the wafer stage cause such varying electromagnetic fields. The electromagnetic crosstalk (EMX) disturbance forces generated by these magnetic fields can lead to overlay errors. The magnitude of the disturbance force depends on many different factors. The main contributors are currents through the wafer stage long-stroke coils and the position of the expose stage. The impact of the disturbance is also influenced by several smaller contributors, such as the presence of magnetic (e.g., shielding) or electrically conductive parts (e.g., eddy current effects) in the path of the magnetic field and the design configuration of the POB.

In other example, the first and the second component may be located in the same device. For example, the wafer stage long stroke movements may also introduce EMX to the wafer stage short stroke and vice versa.

Current state-of-the-art feedback controllers are able to reduce the effect caused by the disturbance forces due to magnetic crosstalk from a second component. However, a downside of feedback controllers is that they are reactive by nature: there must be an error before a correction can be performed. The effect of the disturbance force can be further reduced by using a feedforward controller. In order to create a functioning feedforward controller however, an estimation of the disturbance force is needed as input as input to the feedforward controller. Creating a physics-based prediction model is a difficult task, since many different factors play a role and generating simulation data takes a significant amount of time.

More specifically, the disturbance force on each actuator potentially depends on:

- The current through each of the wafer stage long-stroke coils;
- The position of the expose stage (i.e., the wafer stage used for exposure. Some lithography machines comprise separate wafer stages for measurement/alignment and for exposure);
- The position of the wafer stage balance mass, due to its strong permanent magnets which create a magnetic field at actuator locations, and in particular because it impacts the commutation (current distribution) in the long stroke actuator of the expose stage;
- The position of the measure stage, since it has an impact on the balance mass and may also have a direct crosstalk towards the mirror actuators (although the latter effect is typically small);
- The presence of ferromagnetic parts in the path between the magnet source and the actuator, either functioning as a shield or as a field convergence mechanism. In other embodiments, ferromagnetic parts may also present on the mirror itself;
- The presence of electrically conductive parts, creating eddy-current effects. It is extremely difficult to model eddy current effects in this field;
- The configuration of the actuator and Magnetic Gravity Compensator (which provides a constant lifting force for the mirror such that the actuator does not have to) itself, making it more or less sensitive to magnetic fields.

The relation between these sources, elements in the magnetic path, and the resulting disturbance force is very difficult to model, since a physical model is highly impacted by small details and computation time for one static configuration may take in on the order of days on a high performance cluster. As such, present models are of limited accuracy.

For this reason, using artificial intelligence (AI) is proposed, and in particular a regression tree based AI model, to infer a correction (e.g., a feedforward correction) for control of at least one first component of a lithographic or metrology apparatus which compensates for the effect of (e.g. movement or actuation of) at least one second component of the lithographic or metrology apparatus. A regression tree AI model can learn the relation between an (e.g., electromagnetic) disturbance force on the first component caused by the second component and input parameters related to the second component, based on simulation or measurement without the need to explicitly describe the underlying physics.

A regression tree is a decision tree-based model used in a regression context. It uses a tree-like structure to translate relations observed in the input data to an output value. The tree-like structure can be described as using branches and leaves. At the root of the tree, the regression tree starts splitting up into branches based on conditions for the input data at each branch split. This process continues until a leaf is reached. A leaf is the end point of the tree.

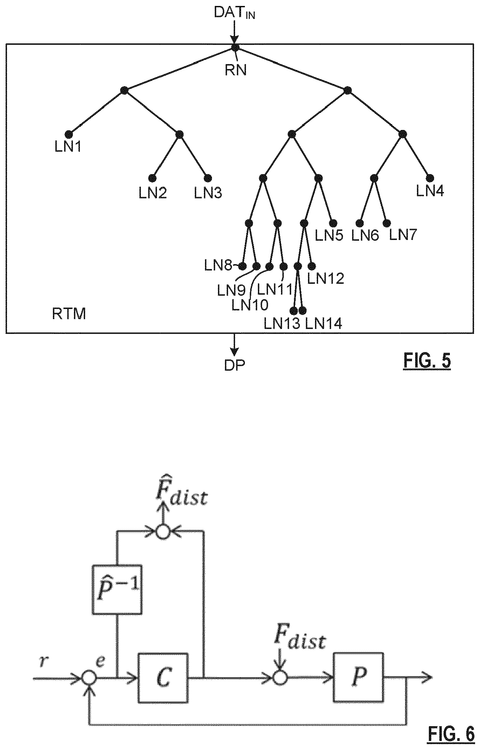

Figure 5 illustrates an exemplary (simplified) regression tree model RTM such as may be used to determine a disturbance parameter DP (e.g. a compensatory force for one or more of the mirrors, which may be a compensatory force described in terms of one or more degrees of freedom, wherein the degrees of freedom may comprise the three spatial dimensions (e.g., x, y, z) and three rotations in these dimensions (e.g., rx, ry, rz)) based on input data $DAT_{IN}$ (e.g., one or more second component or transport stage variables such as, depending on the type of stage, stage motor current, stage position, stage balance-mass position, and possibly stage velocity). Depending on values for the input data $DAT_{IN}$, the input data at the root node RN is mapped to a respective disturbance parameter value at one of the leaf nodes LN1-LN14. Where the disturbance parameter value is a (e.g., feed-forward) correction such as a compensatory force for a mirror, this force can then be applied to the mirror to compensate for the predicted/anticipated disturbance force based on the known stage variables.

The regression tree may be trained in a training stage, based on training data. Such training may be supervised, based on known input data values and corresponding disturbance parameter values. In order to establish a well-performing prediction model with a decision tree method, the training data should comprise a sufficiently representative measurement data set. This data set ideally covers the full range of relevant system dynamics present on a machine.

The regression tree may be trained using an algorithm called recursive binary splitting. At each branch, an evaluation is performed to determine whether splitting a branch into two branches will result in a reduction of the variance or an error metric (e.g., mean square error) within the data. The resulting variance or mean square error of the data at the new branch should be lower than the variance or mean square error at the original branch. This process is repeated for each branch until all branches have reached a stopping parameter such as the minimum leaf size. In each case, deciding where to split a branch may comprise an iterative process of calculating variance or mean square error for all possible splits within the data of each branch and choosing the split that has the least value for the variance or mean square error.

The training may comprise an initial step of defining a minimum leaf size and/or maximum depth of the regression tree. Minimum leaf size determines the minimum number of values in the training data which may be grouped together on a single leaf. As such, the minimum leaf size is a stopping parameter. Increasing this number leads to a more general regression tree, while a low number results in a specific prediction model that more closely fits the training data. The risk of a low minimum leaf size is that the tree will fit the features of the training data in a direct way, which can lead to overfitting. When such a tree will be used on unseen data, the predictions can become inaccurate compared to a more generalized model.

The ideal minimum leaf size will depend on the data. When the training data is sufficiently representative, a small leaf size will lead to a more accurate model and overfitting is not a direct risk. If a more generic model is being built or the training data is sparsely distributed, a larger leaf size will provide better performance. It is difficult to calculate the minimum leaf size upfront, so an optimal value may be decide upon using a parameter sweep or trail-and-error method.

Another parameter that may be tuned is the maximum depth of the tree. This determines the number of branch layers between the starting root and the leaves. This is another way of controlling the generality of the tree; a small depth allows for less detail, while a large depth allows for a more specified branch structure.

When the disturbance parameter is a compensatory mirror force (to compensate for electromagnetic forces on the mirror), these electromagnetic forces cannot be measured directly. As such, a method for determining or extracting this mirror force, to use for training (i.e., to label the input training data) will also be described.

Figure 6 is a mirror feedback flow diagram which conceptually illustrates how a derived mirror disturbance force $\hat{F}_{dist}$ (e.g., a 6 degree of freedom mirror disturbance force) may be extracted using the inverse process sensitivity plant model $\hat{P}^{-1}$ and control output $Ce$, assuming a reference input $r$.

The control error $e$ as function of force disturbance $\hat{F}_{dist}$ is defined by the process sensitivity:

$$e = -\frac{P}{1 + PC} F_{dist}$$

where $P$ is the plant model and $C$ is the control algorithm. $\frac{P}{1+PC}$ is the process sensitivity. Therefore disturbance force $\hat{F}_{dist}$ can be estimated as:

$$\hat{F}_{dist} = -\frac{1 + PC}{P} e = -P^{-1}e - Ce$$

Since nominally (ignoring any dynamics), $P = 1/ms^2$, it holds that $\hat{P}^{-1} = ms^2$, where $m$ is the mirror mass (or inertia in case of rotations) and $s$ is the Laplace operator. As such, the inverse process sensitivity acting on error $e$ can be replaced by the inverse plant model $P^{-1}$ acting on $e$, combined with the controller output $Ce$ to extract the estimated disturbance force $\hat{F}_{dist}$. It should be appreciated that any feedforward control force should not be used for extracting the force disturbance, only the feedback controller output $Ce$ should be used. It should be noted that this concept may be generalized for any disturbance force which cannot be directly measured.

During training for stage-induced magnetic crosstalk to the POB mirrors, as has been described above, a distinction may be made between EMX-related disturbances and mechanically induced disturbances (such that the model is trained to correct only for the former). These phenomena may be distinguished, for example, by moving the measure stage and noting the disturbance on the mirror before making a similar movement of the expose stage and again noting the disturbance force on the mirror. Since the mechanical disturbances are largely the same in both cases, but only movement of the expose stage causes EMX-related disturbances (or at least the expose stage movement is responsible for the majority of the EMX-related disturbances), the mechanical disturbances can be removed e.g., by taking the difference of the two disturbance. However, as measurements show that the mechanically-induced disturbances are much smaller than EMX related disturbances, the risk that the mechanical disturbances will also be learned by the model is minimal. As such, it may be that this distinguishing of the disturbances is not necessary. In any case, even if the training algorithm learns mechanical disturbances in addition to the EMX disturbances it does not automatically mean a performance loss. In general, correlated relations between inputs and outputs may be compensated by such a mechanism.

Regression trees can be made more robust and accurate by combining the computational power of multiple trained trees. These are called ensembles of regression trees. In an embodiment, it is proposed that a plurality or ensemble of regression trees are trained, and once trained used together in inference of the disturbance parameter. To protect against overfitting, assuming a bagged tree method (see below), multiple different trees may be trained with (e.g., randomly chosen) subsets of the learning data. The predicted disturbance force can then be a result of the consolidated output of these trees (e.g., a mean or other average).

A single regression tree can be highly influenced by alterations of the training data. If, for example, part of the training data is removed, the resulting tree can be significantly different from the original tree trained with the full training data. Ensemble methods take advantage of the difference by training multiple trees by training multiple trees on subsets of the training data. Ensemble methods can be divided into two main techniques, either of which may be employed for the methods disclosed herein: bagged trees and boosted trees.

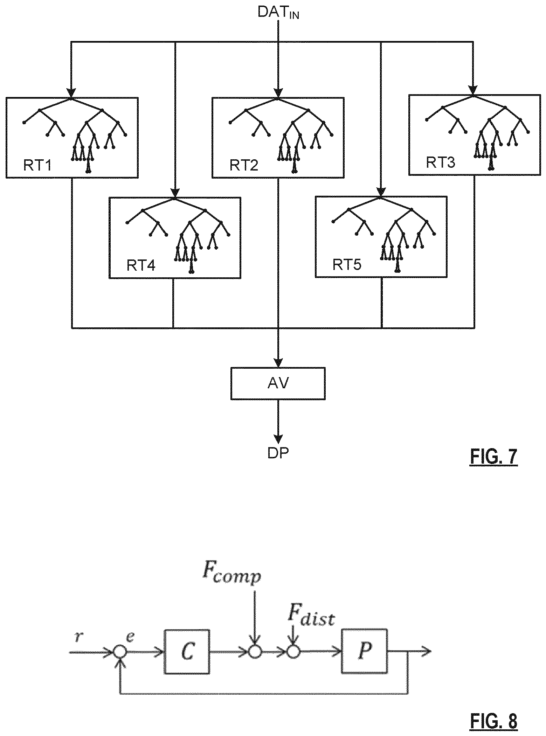

Figure 7 is a flowchart illustrating how such an ensemble method may be used to determine a disturbance parameter DP from input data DAT$_{IN}$. Bagged trees train multiple trees with subsets of the training data. The resulting ensemble of trees RT1-RT5 (here five trees are shown, purely for example) first predicts the desired output value based on the input data per individual tree. The final output DP of the bagged tree may be an average AV of all predicted values. This method makes efficient use of the difference between each tree and provides a more continuous output compared to a single regression tree. Moreover, it reduces overfitting since each tree trains with a different part of the training data. The advantage of this methodology is that bagged trees create a more general prediction model, which is also able to perform well on previously unseen data.

Boosted trees are a method of using sequentially positioned trees to reduce the prediction error of each previous tree. Each successive tree aims to minimize the prediction error of the previous tree. This method is effective in reducing the variance, but risks a higher chance at overfitting.

In such an ensemble model based method, the number of regression trees trained and/or used to infer a disturbance parameter may be a user tunable variable, and the method may comprise tuning the number of regression trees. As with minimum leaf size, the optimal value for the number of parameter is dependent on the data, and may be, for example, found using parameter sweep or trial-and-error methods.

Figure 8 is a flow diagram conceptually indicating how a disturbance parameter, inferred using a trained regression tree based on methods described herein, may be used in control of a mirror (e.g., a mirror for guiding a patterned beam to a wafer in an exposure process). Here the disturbance parameter is a compensatory mirror force $F_{comp}$ which is modeled to compensate for a disturbance force $\hat{F}_{dist}$ on the mirror. As can be seen, the compensatory mirror force $F_{comp}$ is determined prior to the disturbance force $\hat{F}_{dist}$ being applied, and as such is applied to the control as a feedforward correction.

Due to the nature of decision trees generally, significant outliers can be observed in the prediction output. For using a prediction model in practice, large errors should be avoided as much as possible. Since the predictions will be used in a feedforward controller, an inaccurate prediction could lead to unexpected behavior of the machine. An outlier removal may therefore be performed, in an embodiment. For example, a low-pass filter may be provided to filter the model output. For example, the regression tree modeling may comprise a static modeling which does not take time into account. However, dynamically, there will not be a big change from one sample to next, resulting in spikes in the model output. These spikes can be filtered using an (e.g. 500 Hz) low-pass filter. An alternative approach may comprise training the model not to output outlier or sudden spikes.

While the concepts disclosed herein are predominately described in the context of feed-forward mirror control within a projection optics box, to compensate for EMX-related disturbance forces, the method is not limited to such a context. Regression tree based models may be used for other contexts in the lithography or metrology control environment and in particular to any control aspect where there is a strong non-linear relationship between the measured (input) parameters and modeled parameter(s). For example, any interaction, in which a force or actuation of a second component induces an error; e.g., induces an electromagnetic field which in turn affects control of at least one first component may use the concepts disclosed herein.

Such second components may comprise any stage (e.g., wafer stage or reticle stage) in a lithography apparatus or metrology apparatus, the movements of which may cause electromagnetic fields to be generated or changed, which can then cause a disturbance force, or a change in the disturbance force, on a first component. Such one or more first components may comprise one or directing mirrors or one or more other components for directing a beam (e.g., patterning beam or measuring beam), or other components of a transport stage for example. As such, in general, a regression tree based model (or ensemble thereof) maybe used to determine a feed-forward correction for the first component based on relevant control and/or measured data for the second component.

In another specific example, a wafer stage typically comprises a long-stroke actuator and a short-stoke actuator for coarse and fine control respectively. This is the case for lithography and metrology devices generally, including those of the types illustrated in Figures 1, 3 and 4, or other types of metrology device such as a scanning electron microscope/e-beam device. Actuation of the long-stroke actuator may generate unwanted fields which affect/disturb short-stage actuation and vice versa. A regression tree based model (or ensemble thereof) maybe used to determine a feed-forward correction for one of these actuators based on relevant control and/or measured data for the other actuator.

The methods disclosed herein have been demonstrated to reduce the disturbance force on the mirror(s) within a POB to a very significant degree. Using bagged trees as described, for example, the method is able to reduce the disturbance force by 96% or more. The predicted disturbance force can be used as input to a feedforward controller, or a control loop, to mitigate the impact of electromagnetic disturbance on the POB.

A further advantage of a regression tree is that it is interpretable. A specific decision flow is followed for the outcome of each prediction. Hence, when inaccurate predictions occur, the cause of this can be traced back through the regression tree. The difficulty of tracing back decisions becomes more complex when the amount of dimensions of the training data is increased, but the principle remains the same.

Further embodiments of the invention are disclosed in the list of numbered clauses below:

1. A method of determining a correction for control of at least one first component of a lithographic or metrology apparatus; the method comprising:

obtaining a trained regression tree model which has been trained to map input data relating to at least one second component of the lithographic or metrology apparatus to a disturbance parameter related to a disturbance of said at least one first component, said disturbance having been caused by said at least one second component;

obtaining input data relating to said at least one second component; and

determining a compensatory correction for the disturbance parameter from said input data using the trained regression tree model.

2. A method as described in clause 1, wherein said compensatory correction is determined as a feedforward correction, said determination step being performed prior to said disturbance occurring.

3. A method as described in clause 1 or 2, wherein said disturbance parameter is caused by a movement or actuation of said at least one second component.

4. A method as described in any preceding clause, wherein said disturbance parameter comprises an electromagnetic force on said at least one first component.

5. A method as described in any preceding clause, wherein the input data comprises data of one or more parameters related to the movement and/or actuation of said at least one second component.

6. A method as described in clause 5, wherein said one or more parameters comprise one or more of: a velocity, an acceleration, an actuation current and a position of a sub-component of one or more of said at least one second component.

7. A method as described in any preceding clause, wherein the at least one second component comprises one or more of: a substrate stage and a reticle stage.

8. A method as described in any preceding clause, wherein said at least one first component comprises at least one mirror for manipulating and/or guiding a patterned beam to a substrate in a lithographic exposure process.

9. A method as described in any of clauses 1 to 6, wherein the at least one first component comprises a first actuator for either a substrate stage or a reticle stage and said at least one second component comprises a second actuator for said substrate stage or a reticle stage.

10. A method as described in any preceding clause, wherein said trained regression tree model comprises an ensemble of trained regression trees, each of which has been trained on different subsets of training data; and the method comprises determining the compensatory correction from a combined output of said ensemble of trained regression trees.

11. A method as described in clause 10, wherein the compensatory correction is determined as an average of the respective outputs of said ensemble of trained regression trees.

12. A method as described in any preceding clause, comprising performing an outlier removal step on the compensatory correction.

13. A method as described in clause 12, wherein said outlier removal step comprises low-pass filtering the compensatory correction.

14. A method as described in any preceding clause, comprising the step of training a regression tree model on training data to obtain the trained regression tree model, said training comprising applying a recursive binary splitting algorithm on said training data.

15. A method as described in clause 14; wherein said recursive binary splitting algorithm uses reduction of variance or an error metric to determine if and where to split a branch of said training data.

16. A method as described in clause 14 or 15, comprising an initial step of determining a minimum leaf size for the model.

17. A method as described in any of clauses 14 to 16, comprising training an ensemble of regression trees, each regression tree being trained on different subsets of said training data.

18. A method as described in any of clauses 14 to 17, comprising processing the training data by removing a mechanical disturbance parameter contribution to said disturbance parameter.

19. A method as described in any of clauses 14 to 18, wherein the training data relates to a disturbance parameter which is not able to be directly measured, and the method comprises extracting this disturbance parameter from an inverse process sensitivity of a feedback control process of said at least one first component, a control action for the feedback control process and an error signal.

20. A method as described in any preceding clause, comprising applying said compensatory correction to a control action of said at least one first component.

21. A computer program comprising program instructions operable to perform the method of any preceding clause, when run on a suitable apparatus.

22. A non-transient computer program carrier comprising the computer program of clause 21.

23. A processing arrangement comprising:

a computer program carrier comprising the computer program of clause 22; and
a processor operable to run said computer program.

24. A lithographic tool for patterning a substrate or measuring a patterned structure on a substrate; the lithographic tool comprising:

at least one first component;
at least one second component;
a processor; and
a non-transient computer program carrier comprising a trained regression tree model, having been trained to map input data relating to the at least one second component to a disturbance parameter related to a disturbance of said at least one first component, said disturbance having caused by said at least one second component.

25. A lithographic tool as described in clause 24, wherein said computer program carrier further comprises program instructions operable to perform a method of determining a correction for control of said at least one first component; the method comprising:

obtaining input data relating to said at least one second component; and
determining a compensatory correction for the disturbance parameter from said input data using the trained regression tree model.

26. A lithographic tool as described in clause 25, wherein the processor is operable to determine said compensatory correction as a feedforward correction, said determination step being performed prior to said disturbance occurring.

27. A lithographic tool as described in clause 25 or 26, wherein the processor is operable to apply said compensatory correction to a control action of said at least one first component.

28. A lithographic tool as described in clause 25, 26 or 27, wherein the processor is operable to perform an outlier removal step on the compensatory correction.

29. A lithographic tool as described in clause 28, wherein said outlier removal step comprises low-pass filtering the compensatory correction.

30. A lithographic tool as described in any of clauses 24 to 29, wherein said disturbance parameter is caused by a movement or actuation of said at least one second component.

31. A lithographic tool as described in any of clauses 24 to 30, wherein said disturbance parameter comprises an electromagnetic force on said at least one first component.

32. A lithographic tool as described in any of clauses 24 to 31, wherein the input data comprises data of one or more parameters related to the movement and/or actuation of said at least one second component.

33. A lithographic tool as described in clause 32, wherein said one or more parameters comprise one or more of: a velocity, an acceleration, an actuation current and a position of a sub-component of one or more of said at least one second component.

34. A lithographic tool as described in any of clauses 24 to 33, wherein the at least one second component comprises one or more transport stages of the lithographic tool.

35. A lithographic tool as described in clause 34, wherein the at least one first component comprises a first actuator for said one or more transport stages and said at least one second component comprises a second actuator for said one or more transport stages.

36. A lithographic tool as described in clause 34 or 35, wherein said one or more transport stages comprises a reticle stage of the lithographic tool.

37. A lithographic tool as described in clause 34 or 35, wherein said one or more transport stages comprises one or more substrate stages of the lithographic tool.

38. A lithographic tool as described in any of clauses 24 to 37, wherein the lithographic tool is an exposure tool for patterning a substrate.

39. A lithographic tool as described in clause 38, wherein the lithographic tool further comprises projection optics for manipulating and/or guiding a patterned beam to said substrate; and said at least one first component comprises at least one mirror comprised within the projection optics.

40. A lithographic tool as described in any of clauses 24 to 37, wherein said lithographic tool comprises a metrology tool for measuring a patterned structure.

41. A lithographic tool as described in clause 40, wherein the metrology tool is a scatterometer.

42. A lithographic tool as described in clause 40, wherein the metrology tool is a scanning electron microscope or e-beam tool.

43. A lithographic tool as described in any of clauses 24 to 42, wherein said trained regression tree model comprises an ensemble of trained regression trees, each of which have been trained on different subsets of training data.

44. A component controller configured to control a first component, the controller being configured to implement the method of any of clauses 1 to 20.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of determining a correction for control of at least one first component of a lithographic or metrology apparatus; the method comprising:

   obtaining a trained regression tree model which has been trained to map input data relating to at least one second component of the lithographic or metrology apparatus to a disturbance parameter related to a disturbance of said at least one first component, said disturbance having been caused by said at least one second component;
   obtaining input data relating to said at least one second component; and
   determining a compensatory correction for the disturbance parameter from said input data using the trained regression tree model.

2. A method as claimed in claim 1, wherein said compensatory correction is determined as a feedforward correction, said determination step being performed prior to said disturbance occurring.

3. A method as claimed in any preceding claim, wherein said disturbance parameter comprises an electromagnetic force on said at least one first component.

4. A method as claimed in any preceding claim, wherein the input data comprises data of one or more parameters related to the movement and/or actuation of said at least one second component.

5. A method as claimed in any preceding claim, wherein the at least one second component comprises one or more of: a substrate stage and a reticle stage and said at least one first component comprises at least one mirror for manipulating and/or guiding a patterned beam to a substrate in a lithographic exposure process.

6. A method as claimed in any preceding claim, wherein said trained regression tree model comprises an ensemble of trained regression trees, each of which has been trained on different subsets of training data; and the method comprises determining the compensatory correction from a combined output of said ensemble of trained regression trees.

**7.** A method as claimed in any preceding claim, comprising the step of training a regression tree model on training data to obtain the trained regression tree model, said training comprising applying a recursive binary splitting algorithm on said training data.

**8.** A computer program comprising program instructions operable to perform the method of any preceding claim, when run on a suitable apparatus.

**9.** A lithographic tool for patterning a substrate or measuring a patterned structure on a substrate; the lithographic tool comprising:

at least one first component;
at least one second component;
a processor; and
a non-transient computer program carrier comprising a trained regression tree model, having been trained to map input data relating to the at least one second component to a disturbance parameter related to a disturbance of said at least one first component, said disturbance having caused by said at least one second component.

**10.** A lithographic tool as claimed in claim 9, wherein said computer program carrier further comprises program instructions operable to perform a method of determining a correction for control of said at least one first component; the method comprising:

obtaining input data relating to said at least one second component; and
determining a compensatory correction for the disturbance parameter from said input data using the trained regression tree model.

**11.** A lithographic tool as claimed in claim 10, wherein the processor is operable to determine said compensatory correction as a feedforward correction, said determination step being performed prior to said disturbance occurring.

**12.** A lithographic tool as claimed in claim 10 or 11, wherein the processor is operable to apply said compensatory correction to a control action of said at least one first component.

**13.** A lithographic tool as claimed in any of claims 9 to 12, wherein the at least one second component comprises one or more transport stages of the lithographic tool.

**14.** A lithographic tool as claimed in any of claims 9 to 12, wherein the lithographic tool is an exposure tool for patterning a substrate; and further comprises projection optics for manipulating and/or guiding a patterned beam to said substrate; and said at least one first component comprises at least one mirror comprised within the projection optics.

**15.** A lithographic tool as claimed in any of claims 9 to 12, wherein said lithographic tool comprises a metrology tool for measuring a patterned structure.

Fig. 1

Fig. 2

FIG. 3

Fig. 4

FIG. 5

FIG. 6

DAT$_{IN}$

RT1

RT2

RT3

RT4

RT5

AV

DP

**FIG. 7**

$F_{comp}$

$F_{dist}$

$r$    $e$    $C$    $P$

**FIG. 8**

Europäisches
Patentamt

European
Patent Office

Office européen
des brevets

# EUROPEAN SEARCH REPORT

Application Number

EP 22 16 8402

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2008/067967 A1 (BUTLER HANS [NL]) 20 March 2008 (2008-03-20) * abstract * * figure 1 * * paragraphs [0001], [0005], [0008], [0040] - [0051] * | 1-15 | INV. G03F7/20 |
| A | US 2021/389675 A1 (SHIH PO-MING [TW] ET AL) 16 December 2021 (2021-12-16) * abstract * * figure 1 * * paragraphs [0001], [0033] - [0050] * | 1-15 | |
| A | US 2016/170311 A1 (SCHMITT-WEAVER EMIL PETER [NL] ET AL) 16 June 2016 (2016-06-16) * abstract * * figures 1,2 * * paragraphs [0002], [0004], [0048] - [0055] * | 1-15 | |

TECHNICAL FIELDS SEARCHED (IPC)

G03F

The present search report has been drawn up for all claims

| Place of search | Date of completion of the search | Examiner |
|---|---|---|
| Munich | 7 October 2022 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 16 8402

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-2022

| Patent document cited in search report | | Publication date | Patent family member(s) | | Publication date |
|---|---|---|---|---|---|
| US 2008067967 | A1 | 20-03-2008 | JP | 4669868 B2 | 13-04-2011 |
| | | | JP | 2008141165 A | 19-06-2008 |
| | | | US | 2008067967 A1 | 20-03-2008 |
| US 2021389675 | A1 | 16-12-2021 | CN | 113275741 A | 20-08-2021 |
| | | | TW | 202201136 A | 01-01-2022 |
| | | | US | 2021389675 A1 | 16-12-2021 |
| US 2016170311 | A1 | 16-06-2016 | TW | 201514638 A | 16-04-2015 |
| | | | US | 2016170311 A1 | 16-06-2016 |
| | | | WO | 2015024783 A1 | 26-02-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B

- US 12486449 B
- US 12920968 B
- US 12922587 B
- US 13000229 B
- US 13033135 B
- US 13533110 B
- US 13891410 B
- WO 2011012624 A
- US 20160161863 A